# EUROPEAN PATENT APPLICATION

(11) **EP 4 686 016 A1**
(43) Date of publication of application: **28.01.2026**
(21) Application number: 24190884.7
(22) Date of filing: 25.07.2024
(51) Int. Cl.: H01S 5/183, H01S 5/14, H01S 5/04, H01S 3/06, H01S 3/105, H01S 3/109, H01S 5/06

(54) **GAIN MODULATION OF VERTICALLY EMITTING SEMICONDUCTOR LASERS**

(71) Applicant: Twenty-One Semiconductors GmbH, 72654 Neckartenzlingen (DE)
(72) Inventor: WITZ-HASZLER, Norbert, 72654 Neckartenzlingen (DE); BEK, Dr. Roman, 72654 Neckartenzlingen (DE); SEIBOLD, Matthias, 72654 Neckartenzlingen (DE); SCHARWAECHTER, Michael, 72654 Neckartenzlingen (DE)
(74) Representative: Weilnau, Carsten

(57) **Abstract**

The present disclosure relates to a semiconductor laser comprising:
- a first reflector (12),
- a second reflector (14) separated from the first reflector (12) along a longitudinal direction (z),
- a resonant cavity (8) confined by the first reflector (12) and by the second reflector (14),
- a periodic gain structure (16) inside the resonant cavity (8), the periodic gain structure (16) is separated from the first reflector (12) by a first optical path length (L1) and is separated from the second reflector (14) by a second optical path length (L2), wherein the first optical path length (L1) is shorter than the second optical path length (L2), characterized in that
- the first optical path length (L1) between the periodic gain structure (16) and the first reflector (12) is adjustable.

## Description

### Field of the invention

The present invention relates to the field of semiconductor lasers, in particular to the field of spectral control of vertically emitting semiconductor lasers.

### Background

Optically pumped semiconductor lasers, e.g. implemented as vertically emitting semiconductor lasers are well-known in the art. One example of an optically-pumped external-cavity surface-emitting semiconductor laser, is e.g. described in US 7 717 964 B2.

Generally, vertically emitting semiconductor lasers provide high output power and excellent beam properties over a wide range of wavelengths. In addition, the provision of an external resonator arranged externally to the semiconducting layer structure enables the operation of the semiconductor laser to be influenced by optical elements in order to achieve, for example, a narrow line width, a tunable emission wavelength, efficient frequency conversion and/or the emission of ultrashort pulses of laser light.

However, depending on the wavelength of emission of the laser light and thus also on the material system of the amplifier medium in the semiconductor laser, the implementation of this laser concept is currently only possible with a great deal of technical and financial effort.

With optically pumped semiconductor lasers, specifically with so-called vertical cavity surface emitting lasers or vertical external-cavity surface emitting lasers an optically active region or layer may comprise a gain structure comprising multiple quantum wells. The quantum wells are typically arranged in a periodic fashion wherein the optical distances between the quantum wells are an integer multiple of the half of the targeted laser wavelength. Such an arrangement is called periodic gain structure. Typically, vertically emitting semiconductor lasers are designed in an active mirror geometry, in which the periodic gain structure and a distributed Bragg reflector are monolithically integrated by growth or post-growth bonding. This active mirror geometry results in a comparatively wide spectral bandwidth of the laser.

The periodic gain structure is typically located between a first and a second reflector confining the laser cavity or resonant cavity. During operation the quantum wells and hence the periodic gain structure provides optical gain and may be in a fixed relationship to the standing wave pattern of the resonator or resonant cavity. Matching of the periodic gain structure with the standing wave pattern of the intracavity laser radiation may be assured by monolithic construction of the optically pumped semiconductor laser.

As a rear reflector, e.g. a first reflector of the optically pumped semiconductor laser, may be monolithically integrated within the stack of layers of the optically pumped semiconductor laser, a relative position of the first mirror to the periodic gain structure and hence to the quantum well may be determined at the time of the epitaxial growth of the multilayer structure of the semiconductor laser.

When the standing wave of the intracavity laser radiation, hence the electric field of the intra-cavity laser radiation is phase shifted to the periodicity of the periodic gain structure only a suboptimal gain of the semiconductor laser may be obtained.

For many application scenarios the comparatively wide spectral width of such semiconductor lasers may require a restriction and suitable limitation, which may be obtained by etalons or birefringent filters in the laser cavity. Such spectral filters always impose optical losses and may require a rather elaborate and costly assembly and adjustment.

Also, and for some applications, it would be desirable, to tune or to shift the spectral composition of the laser emission during use. Here, it might be possible to change a configuration of optical filter elements, e.g. by a mechanical movement or rotation of such filters inside the resonator cavity. Mechanically movable parts are rather complicated to implement and may require a further adjustment. They may further impose a temporal limit for adjusting the spectral composition of the laser emission. In general, a movement of mechanical components may not enable a fast and prompt reaction or sweeping of the spectral composition of the laser radiation.

In view of the above it is hence desirable to improve vertically emitting semiconductor lasers in terms of their spectral control as well as with regards to their wavelength tunability.

### Summary

The above-mentioned drawbacks are solved by a semiconductor laser and by a method of spectrally controlling such semiconductor lasers with the features of the independent claims. Preferred examples and embodiments are subject matter of respective dependent claims.

In one aspect there is provided a semiconductor laser. The semiconductor laser comprises a first reflector and a second reflector. The second reflector is separated from the first reflector along a longitudinal direction. The semiconductor laser further comprises a resonant cavity or resonator, which is confined by the first reflector and by the second reflector. The resonant cavity may be confined at opposite longitudinal ends by the first and by the second reflector, respectively. Hence, the first reflector may define a first end of the elongated resonant cavity and the second reflector may confine or delimit an opposite longitudinal end of the resonant cavity.

The semiconductor laser further comprises a periodic gain structure inside the resonant cavity. The periodic gain structure is separated from the first reflector by a first optical path length. The periodic gain structure is further separated from the second reflector by a second optical path length. Here, the first optical path length is shorter than the second optical path length. Insofar, the periodic gain structure is arranged inside the resonant cavity in an asymmetric manner. It is located closer to the first reflector than to the second reflector in terms of respective first and second optical path length. The periodic gain structure may be located off-center inside the resonant cavity as seen in longitudinal direction. The periodic gain structure may also comprise or constitute an active region of the semiconductor laser. It may comprise or form a membrane-type laser-active structure or laser gain layer.

The periodic gain structure may extend along the longitudinal direction. The periodicity of the gain structure may repeat along the longitudinal direction.

Furthermore, the first optical path length and hence the optical path length between the periodic gain structure and the first reflector is adjustable. By providing an adjustment between the first reflector and the periodic gain structure for a given resonator wavelength there can be rather precisely adjusted a phase matching between the standing wave of the intracavity laser radiation and the periodic gain structure. Hence, an amplitude or intensity maximum of the electric field of the standing wave inside the resonant cavity may be brought in precise overlapping configuration with the periodic gain structure in order to obtain a maximum or optimized gain of the semiconductor laser.

Moreover, by varying the optical path length between the periodic gain structure and the first reflector there can be provided a rather precise and elegant spectral filtering for the semiconductor laser. The adjustability of the optical path length and hence of optical distance between the first reflector and the periodic gain structure may provide a rather effective spectral filtering for the semiconductor laser. The adjustability of the optical distance between the first reflector and the periodic gain structure may replace other spectral filters, such as etalons or birefringent filters inside the resonant cavity. In this way a total number of optical components of the semiconductor laser can be reduced.

Adjusting of the first optical path length between the periodic gain structure and the first reflector may be obtained in a variety of different ways. According to one example the geometric or physical distance between the periodic gain structure and the first reflector may be adjustably varied. According to other examples the refractive index of a medium located between the first reflector and the periodic gain structure may be varied, e.g. by change of temperature or applying a voltage, which may have an equal optical path length adjusting effect. In still other examples it is conceivable that the optical path length may be varied by selecting a specific spacer from a set of spacers of different longitudinal size or longitudinal extent.

The adjustability of the first optical path length may also provide an intra-cavity spectral filtering of the emitted laser radiation without the necessity of introducing respective filter elements, such as etalons or birefringent filters. Insofar the total number of components may be reduced and optical losses that would inevitably come along with such filters can be avoided and reduced.

Moreover, and by adjusting the first optical path length during operation of the semiconductor laser a spectral composition of the emitted laser radiation can be varied rather promptly and there can be provided a spectral modification of the laser radiation at a comparatively high sweep rate or sweep velocity. The adjustment of the optical path length may be also implemented in a rather compact design.

According to some examples the semiconductor laser is implemented as a pumped semiconductor laser.

It may be implemented as an optically pumped semiconductor laser.

According to further examples, the semiconductor laser is implemented as an electrically pumped semiconductor laser.

According to some examples the semiconductor laser is a vertically emitting semiconductor laser, wherein the vertical direction extends along the longitudinal direction.

According to some examples the periodic gain structure is a resonant periodic gain structure.

Specifically, by the adjustability of the first optical path length between the periodic gain structure or resonant periodic gain structure and the first reflector there can be provided a precisely controllable or precisely controlled matching between the periodicity of the periodic gain structure and the standing wave of the intra-cavity laser radiation. There can be further provided a control of a matching or geometrical overlap between the standing wave of the intra-cavity laser radiation and the periodic gain structure.

According to a further example a longitudinal distance, hence a distance along the longitudinal direction between the first reflector and the periodic gain structure is adjustable. This can be obtained by adjusting the position of the first reflector relative to the periodic gain structure and/or by adjusting or moving the position of the periodic gain structure relative to the first reflector.

Accordingly, the first reflector and the periodic gain structure may be adjustably displaceable relative to each other. In some examples the first reflector and the periodic gain structure may be directly connected to each other. In some examples the first reflector may be mounted or attached to the periodic gain structure. It may be movably attached or movably fastened to the periodic gain structure in order to provide a suitable and intended longitudinal adjustment of the optical path length there between.

According to a further example the periodic gain structure and the first reflector may be connected or mutually fastened indirectly, e.g. via a base, to which both, the first reflector and the periodic gain structure, may be attached or fixed separately. Here, at least one of the periodic gain structure and the first reflector may be adjustably movable relative to the base in order to enable a variation or adjustment of the longitudinal distance between the first reflector and the periodic gain structure.

According to a further example the first reflector is movable in longitudinal direction relative to the periodic gain structure. In further examples it is the periodic gain structure that is movable in longitudinal direction relative to the first reflector. In still further examples both, the first reflector and the periodic gain structure may be movable relative to each other. Generally, at least one or both of the periodic gain structure and the first reflector may be adjustably movable relative to a common base, to which the periodic gain structure and the first reflector are attached or mounted to.

According to a further example the periodic gain structure is adjustably movable relative to at least one of the first reflector and the second reflector along the longitudinal direction. Here, it may be conceivable that the periodic gain structure is adjustably movable relative to the second reflector. In some examples the periodic gain structure may be fixed or connected to the second reflector. By moving the periodic gain structure relative to the second reflector there can be provided an indirect respective movement between the periodic gain structure and the first reflector when the first reflector may be fixed to the second reflector.

According to a further example also the second reflector is adjustably movable relative to at least one of the first reflector and the periodic gain structure along the longitudinal direction. In further examples it may be even provided that the second optical path length between the periodic gain structure and the second reflector is adjustable. A variation of the second optical path length may be obtained by a longitudinal relative displacement between the second reflector and the periodic gain structure. It may be also obtained by varying a refractive index of a medium, which is located in the optical path between the periodic gain structure and the second reflector.

According to some examples the first and second reflectors may be adjustable in longitudinal direction relative to each other, e.g., in order to provide a fine tuning of the standing wave propagating in the resonant cavity. In addition, it may be provided that the periodic gain structure is movable relative to at least one of the first and the second reflector to vary the first optical path length, i.e. the optical path length between the periodic gain structure and the first reflector. This may provide a desirable matching or overlapping between the phase of the standing wave in the resonant cavity and the periodic gain structure. In this way, overall gain and/or efficiency of the semiconductor laser can be improved.

According to a further example the semiconductor laser comprises a planar substrate. The periodic gain structure is provided on and extends across one side of the planar substrate. In some examples the periodic gain structure may even constitute the planar substrate. The semiconductor laser may further comprise at least one or numerous supplemental layers, that may be epitaxially grown on the substrate. The entire semiconductor laser may be provided as a chip, which is based on the substrate.

In some examples the semiconductor laser comprises an external cavity semiconductor laser, e.g. an external cavity optically pumped semiconductor laser. Here, the periodic gain structure may be provided on a substrate and at least one of the first and the second reflectors may be located at a predefined distance remote from the respective substrate.

According to a further example the first reflector is attached to the periodic gain structure. It may belong to an epitaxially grown or bonded multilayer structure of the semiconductor laser chip.

In some examples the first reflector may be fixed to or relative to the periodic gain structure. Such a fixing may be obtained after an adjustment of the first optical path length between the periodic gain structure and the first reflector.

According to another example the semiconductor laser comprises a spacer, which is located between the periodic gain structure and the first reflector. The first optical path length between the first reflector and the periodic gain structure may be then adjustable by at least one of varying a longitudinal extent of the spacer, varying a refractive index of the spacer and/or by selecting at least one or numerous spacers from a set of spacers of equal or different longitudinal size or longitudinal extent.

In some examples the first reflector is attached or fixed to the periodic gain structure via the spacer. By varying a longitudinal extent or by suitably selecting one spacer from a set of differently sized spacers the first optical path length between the periodic gain structure and the first reflector can be appropriately adjusted or modified.

In some examples and when the spacer is transparent for the laser radiation the spacer may be also located in the optical path between the first reflector and the periodic gain structure. Now and by varying the refractive index of the spacer the first optical path length between the periodic gain structure and the first reflector can be modified or varied and hence adjusted accordingly.

In some examples the spacer is implemented as a passive spacer. A variation of the longitudinal extent of the spacer may be then obtained by e.g. varying the temperature or by varying the refractive index of the spacer, e.g. by moving or otherwise manipulating the spacer. In further example the spacer may be implemented as an active spacer, which may be electronically controllable to vary at least one of its longitudinal extent and or its refractive index.

According to some examples the first reflector is mounted or mechanically connected to the periodic gain structure via the spacer. Then and by varying or adjusting the longitudinal extent of the spacer a respective distance between the periodic gain structure and the first reflector can be varied or adjusted accordingly.

According to a further example the semiconductor laser comprises a first electrically controllable actuator, which is mechanically connected to at least one of the first reflector and the periodic gain structure. The first electrically controllable actuator is operable to adjust the first optical path length between the first reflector and the periodic gain structure through varying a longitudinal distance between the first reflector and the periodic gain structure.

In some examples the electrically controllable actuator may comprise at least one of a piezo-based actuator and a micro-electro-mechanical system (MEMS) by way of which a longitudinal distance between the first reflector and the periodic gain structure can be adjusted or modified.

According to further examples the first electrically controllable actuator may be connected or engaged with the spacer. In further examples the first reflector may be connected or fastened to the periodic gain structure via the first electrically controllable actuator. Here, the electrically controllable actuator may provide a two-fold function. It may provide a fastening and hence a mechanical attachment or mutual mounting between the periodic gain structure and the first reflector.

It may further provide a variable, adjustable or modifiable longitudinal distance between the periodic gain structure and the first reflector.

According to further examples the first electrically controllable actuator may be located between a base and one of the first reflector and the periodic gain structure. Here, at least one of the first reflector and the periodic gain structure may be attached or connected to the base via the first electrically controllable actuator. The other one of the first reflector and the periodic gain structure may be fixed, i.e. immovably fixed to the base. Here, and by way of the first electrically controllable actuator a longitudinal position of at least one of the first reflector and the periodic gain structure relative to the base can be varied or adjusted whereas the other one of the first reflector and the periodic gain structure remains fixed to the base.

Here, the first reflector and the periodic gain structure may be indirectly fastened or connected to each other through the base and/or via the mount by way of which the first reflector and/or the periodic gain structure can be attached and/or fixed to the common base.

According to a further example the semiconductor laser comprises a second electrically controllable actuator, which is mechanically connected to the second reflector. The second electrically controllable actuator is operable to adjust the second optical path length between the second reflector and the periodic gain structure by varying a longitudinal distance between the second reflector and the periodic gain structure. The second electrically controllable actuator may be operable to operate independently of the first electrically controllable actuator. By way of the second electrically controllable actuator the second reflector can be adjusted, displaced or moved in longitudinal direction relative to the first reflector and/or relative to the periodic gain structure.

By way of first and second electrically controllable actuators there can be provided both, a variable longitudinal position between the periodic gain structure and any of the first and second reflectors. Likewise, and by way of first and second electrically controllable actuators the first reflector can be moved in longitudinal direction separately and independently from the second reflector. This way, a relative longitudinal position between the first reflector and the periodic gain structure as well as between the first reflector and the second reflector can be modified and adjusted.

Here, the semiconductor laser may provide both, an overall longitudinal length adjustment of the resonant cavity as well as a variable and adjustable positioning of the periodic gain structure inside the cavity with regard to the longitudinal direction, i.e. relative to any one of the first and second reflectors. In this way, there can be provided an effective spectral tuning of the semiconductor laser as well as an adjustment of the gain of the semiconductor laser.

According to a further example the optical path length between the first reflector and the periodic gain structure is larger than 5 times or larger than 10 times a target wavelength of the semiconductor laser. In this way, a spectral width of a gain maximum of the semiconductor laser can be easily adjusted and controlled. With an optical path length between the first reflector and the periodic gain structure between 5 times and 50 times the target wavelength the spectral width of the gain maximum may be large enough for providing a respective gain control, e.g. with one of the first and the second electrically controllable actuators and/or or with a variation of the refractive index of the spacer.

According to a further example the optical path length between the first reflector and the periodic gain structure is less than 100 times, less than 50 times, less than 30 times, less than 20 times or less than 15 times a target wavelength of the semiconductor laser. In some examples the optical path length between the first reflector and the periodic gain structure is between 5 times and 20 times the target wavelength of the semiconductor laser. According to further examples the optical path length between the first reflector and the periodic gain structure is between 7 times and 15 times a target wavelength of the semiconductor laser. In this way, there can be provided a rather easy and straightforward tuning as well as gain modulation of the semiconductor laser by adjusting and/or varying the longitudinal distance between the first reflector, the second reflector and the periodic gain structure.

According to a further example the semiconductor laser comprises a controller by way of which the electrically controllable actuator can be effectively controlled.

According to a further example the semiconductor laser comprises a heat spreader, which is in thermal contact with the periodic gain structure.

In some examples the heat spreader is located on the outside of the periodic gain structure that faces away the first reflector. The heat spreader may be monolithically integrated in the semiconductor laser. It may be epitaxially grown on the periodic gain structure, or vice versa, the periodic gain structure may be epitaxially grown on the heat spreader.

According to further examples, the heat spreader may be connected or fixed to the periodic gains structure through a mutual or direct bonding between the heat spreader and the periodic gain structure. Here, the heat spreader and the periodic gain structure may be manufactured or grown separately and may be mechanically connected or fixed through a mutual bonding operation.

The heat spreader may comprise a monolithic layer comprising at least one of silicon carbide, diamond, or aluminum oxide. Of course, the heat spreader is transparent for the laser radiation emitted by the periodic gain structure.

According to a further example the heat spreader comprises an outside surface that faces away the periodic gain structure. The outside surface is provided with at least one of an at least partially reflective coating and the second reflector. When the outside surface of the heat spreader is provided with an at least partially reflective coating the coating may provide a kind of a coupler for outcoupling the laser radiation. Here, the partially reflective coating may also represent or may constitute the second reflector, which may be fixed to the heat spreader and hence to the periodic gain structure. Here, the semiconductor laser may comprise a vertical cavity surface emitting laser.

According to a further example the heat spreader comprises an outside surface that faces away the periodic gain structure. Here, the outside surface may be provided with an antireflective coating. In this way, intracavity losses of radiation can be reduced to a minimum. The laser radiation can be coupled out of the cavity by a separate partially transparent mirror, which may be located between the first and the second reflectors. The separate mirror may be located between the heat spreader and the second reflector and may be oriented at a predefined beveled angle with respect to the longitudinal direction.

In in other examples of the semiconductor laser the second reflector is located separate from the periodic gain structure and/or and may be separated from the optional heat spreader. There may be provided a free space or an air gap between the second reflector and at least one of the heat spreader and the periodic gain structure. Here, the semiconductor laser may be implemented as an external cavity surface emitting semiconductor laser.

With an external second reflector the outside surface of the heat spreader may be provided with an antireflective coating to reduce intracavity losses of the semiconductor laser.

According to a further example the optically pumped semiconductor laser is pumped by an external light source. The external light source may be positioned remote from the first reflector. Hence, the periodic gain structure may be optically pumped via and/or through the first reflector. Here, the first reflector may be substantially transparent for the pump radiation while it is substantially reflective for the stimulated radiation emanating from the periodic gain structure and propagating inside the laser cavity.

According to a further example at least one of the first reflector and the second reflector comprises a distributed Bragg reflector (DBR). The material(s) used in the DBR can be selected from the at least one or several of the following materials or material combinations: SiO₂, Nb₂O₅, HfO₂, TiO₂, Al₂O₃, Ta₂O₅, AlGaAs, InGaAs and AIGalnP and AIGalnAsP.

According to a further example the semiconductor laser comprises a multi layered chip, which includes at least the periodic gain structure. The chip may further comprise the heat spreader monolithically grown or bonded to the periodic gain structure. The multilayer chip may further comprise the first reflector attached to or grown or deposited onto the outside of the periodic gain structure facing away the heat spreader.

In further examples the multilayer chip may be provided with a spacer, e.g. located between the first reflector and the periodic gain structure. The spacer may be also monolithically and/or epitaxially grown on at least one of the first reflector and the periodic gain structure. Alternatively, the multilayer chip may be obtained by a separate epitaxial growth of at least one of the above-mentioned layers and by a subsequent mutual bonding of layers.

In another aspect the present disclosure also relates to a method of spectrally controlling a semiconductor laser as described above. The method comprises the steps of providing the above-mentioned semiconductor laser and adjusting the first optical path length between the periodic gain structure and the first reflector. Adjustment of the first optical path length between the periodic gain structure and the first reflector may be obtained in different ways, e.g., by selecting at least one or numerous spacers from a set of spaces and by arranging the selected spacer between the periodic gain structure and the first reflector. Here, the first reflector may be attached or fixed to the periodic gain structure via the spacer.

The spectral controlling of the semiconductor laser may be obtained by precisely adjusting the first optical path length between the periodic gain structure and the first reflector. The adjustment or final adjustment may take place during manufacture of the semiconductor laser. With some examples the first optical path length may be even adjustable after a final assembly of the semiconductor laser and after delivery to end consumers. Here, the semiconductor laser may be spectrally tunable, e.g. during a calibration procedure, e.g., in the course of activating laser emission.

An adjustment of the first optical path length between the periodic gain structure and the first reflector may be also obtained by varying a longitudinal extent of the spacer, e.g. by using a spacer with a well-defined coefficient of thermal expansion and by adjusting the temperature of the spacer accordingly so as to obtain a respective thermally induced longitudinal dilatation or contraction of the spacer leading to a respective modification of its refractive index and/or to a modification of the spatial distance between the periodic gain structure and the first reflector. In further examples it may be provided that the spacer is transparent for the laser radiation and that the spacer is located in the optical path between the periodic gain structure and the first reflector. Here, the refractive index of the spacer may be adjustable or variable. The spacer may comprise an electro-optical element, which provides a modification or tuning of its refractive index on the basis of an electric control signal applied to the electro-optical element.

In still further examples the spacer may provide a refractive index modulation or variation of the refractive index along the longitudinal direction depending on an orientation of the spacer. Hence, the spacer may be arranged in a rotational manner, e.g., with regards to the longitudinal axis as an axis of rotation. Here, different rotational positions of the spacer may provide different effective refractive indices for the laser radiation between the first reflector and the periodic gain structure.

In general and since the method of spectrally controlling the semiconductor laser makes use of a semiconductor laser as described above, all features, effects and benefits as described above in connection with the semiconductor laser equally apply to the method of tuning or spectrally controlling the semiconductor laser; and the vice versa.

According to a further example the method further includes the step of adjusting the second optical path length between the periodic gain structure and the second reflector. This may be obtained by making use of a second electrically controllable actuator by way of which the second optical path length or distance between the second reflector and the periodic gain structure can be varied or adjusted. The second optical path length may be adjusted or modified in the same or like manner as described above in connection with the first optical path length. Here, the same or like features as described above in connection with the first reflector may be now applied or implemented in a likewise or corresponding manner with the second reflector.

Moreover, the second optical path length may be likewise modified or adjusted by varying a refractive index or by varying a longitudinal extent of a spacer located between the periodic gain structure and the second reflector. Also, the second reflector may be attached or fastened to the periodic gain structure via a spacer. In still further examples the second optical path length between the second reflector and the periodic gain structure may be adjusted by selecting one spacer or multiple spacers from a set of spacers of different longitudinal size and by arranging such spacer(s) between the periodic gain structure and the second reflector.

It should be noted that, as far as technically feasible or possible, any features, structures or effects described herein in connection with only one example or embodiment equally apply also to any other example or embodiment as disclosed herein.

### Brief Description of the Drawings

In the following, numerous examples and embodiments of a semiconductor laser will be described in greater detail by making reference to the drawings, in which:
- Fig. 1: schematically illustrates one example of an optically pumped semiconductor laser according to the present invention,
- Fig. 2: shows a further example of a semiconductor laser,
- Fig. 3: shows another example of the semiconductor laser,
- Fig. 4: shows a further example of the semiconductor laser,
- Fig. 5: shows another example of the semiconductor laser,
- Fig. 6: shows a further example of the semiconductor laser,
- Fig. 7: shows another example of the semiconductor laser,
- Fig. 8: shows another example of the semiconductor laser,
- Fig. 9: shows a further example of the semiconductor laser,
- Fig. 10: shows a diagram illustrating the electric field intensity in the periodic gain structure for different distances between the first reflector and the periodic gain structure,
- Fig. 11: shows numerous graphs illustrating an integrated gain factor over the laser wavelength for different first optical path lengths between the periodic gain structure and the first reflector,
- Fig. 12: shows the integrated gain factor for a number of slightly different first optical path lengths between the periodic gain structure and the first reflector, and
- Fig. 13: is a flowchart of the method of tuning the optically pumped semiconductor laser.

### Detailed description

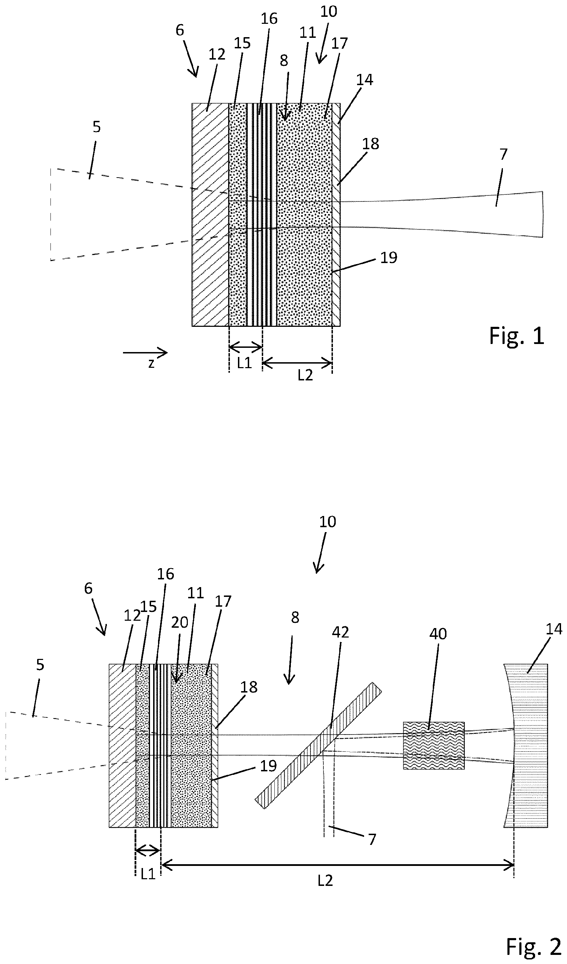

In Figs. 1-9 numerous examples of an optically pumped semiconductor laser 10 are illustrated. The semiconductor laser 10 comprises a first reflector 12 and a second reflector 14, which is separated from the first reflector 12 along a longitudinal direction z. The first and the second reflectors 12, 14 form and hence confine a resonant cavity 8, which forms or constitutes the laser cavity. There is further provided a periodic gain structure 16 inside the resonant cavity 8. The periodic gain structure 16 is separated from the first reflector 12 by a first optical path length L1 and is further separated from the second reflector 14 by a second optical path length L2.

As illustrated in the example of Figs. 1, 2 and 5 the first optical path length L1 is smaller than the second optical path length L2. Hence, the periodic gain structure is longitudinally arranged off-center inside the resonant cavity 8. It is closer to the first reflector 12 than to the second reflector 14.

The semiconductor laser 10 is optically pumped by a pump radiation 5 as indicated in the various examples of Figs. 1-9. The semiconductor laser 10 is to be optically pumped through the first reflector 12. Hence, the first reflector 12 is substantially transparent for the pump radiation 5. It is highly reflective for the laser radiation inside the resonant cavity 8.

The optically pumped semiconductor laser 10 as described herein comprises the first optical path length L1 between the periodic gain structure 16 and the first reflector 12, which is adjustable. The adjustability of the first optical path length L1 allows to selectively and individually adjust or tune the gain of the semiconductor laser 10. Specifically, by adjusting the first optical path length L1 it is possible to appropriately aligned or overlap the standing wave of the intracavity radiation with the periodic pattern of the periodic gain structure 16. In this way, the various layers of different refractive index of the periodic gain structure 16 may overlap, match and/or align with the standing wave and hence with the amplitude of the electromagnetic field of the emitted radiation 7.

The semiconductor laser 10 may comprise a spacer 15, which is located between the periodic gain structure 16 and the first reflector 12. Here, the first reflector 12 may be attached or fastened to the periodic gain structure 16 via the spacer 15. The spacer 15 may be made of a transparent material, i.e. a material that is transparent for the emitted radiation 7.

As further illustrated in the various examples of Figs. 1-9 the semiconductor laser 10 may be further provided with a heat spreader 17. The heat spreader 17 may comprise or constitute a substrate 11 of the semiconductor laser 10. The periodic gain structure 16 may be attached, grown or bonded to one side of the heat spreader 17. An opposite side, e.g. an outside facing surface 19 of the heat spreader 17 or substrate 11 may be provided with a coating 18.

With some examples heat spreader comprise one of several materials selected from the group of thermally conductive materials comprising silicon carbide, diamond, or aluminum oxide.

In the example of Fig. 1 the coating 18 may be partially reflective for the emitted radiation 7. Here, the coating 18 may provide or form the second reflector 14. With all other examples the second reflector 14 is located remote from the chip 6 as formed or constituted by the periodic gain structure 16, the substrate 11 and the heat spreader 17.

Here, the optically pumped semiconductor laser 10 may be implemented as a vertical cavity surface emitting semiconductor laser.

In order to reduce intracavity losses the outside surface 19 of the heat spreader 17 may be provided with an anti-reflective coating 18. Typically, the periodic gain structure 16 comprises a quantum well or numerous quantum wells. Typically, the active or lasing medium comprising or constituting the periodic gain structure is selected from the group of semiconducting materials comprising or consisting of: AIGalnAsP (including AlGaAs, InGaAs and AIGalnP), AllnGaN, or AIGalnAsSb or AIGalnNAs.

The first reflector 12 and/or the second reflector 14 comprise(s) a distributed Bragg reflector. It may comprise numerous layers of materials having different and mutually adjusted indices of refraction. The material(s) used in the layer(s) can be selected from the at least one or several of the following materials or material combinations: SiO₂, Nb₂O₅, HfO₂, TiO₂, Al₂O₃, TazOs, and AIGalnAsP (including AlGaAs, InGaAs and AIGalnP)

In the example as shown in Fig. 2 the semiconductor laser 10 and hence the semiconductor laser chip 6 comprises the first reflector 12, which is connected to a first spacer 15. The first spacer 15 is connected or bonded to one side of the periodic gain structure 16. An opposite side of the periodic gain structure 16 is connected or bonded to the heat spreader 17 and an outside surface 19 of the heat spreader 17 facing away the periodic gain structure 16 is provided with a coating 18. Between the chip 6 and the second reflector 14, which may be a curved, e.g. a concave shaped curved reflector 14 there may be provided a gap or free space. In the gap or intermediate space between the chip 6 and the external cavity reflector 14 there may be provided a frequency conversion crystal 40 by way of which there may be provided a second harmonic radiation compared to the stimulated emission of the periodic gain structure 16. There may be further provided a coupler 42, e.g. in form of a dichroic mirror by way of which the second harmonic radiation can be coupled out of the resonant cavity 8.

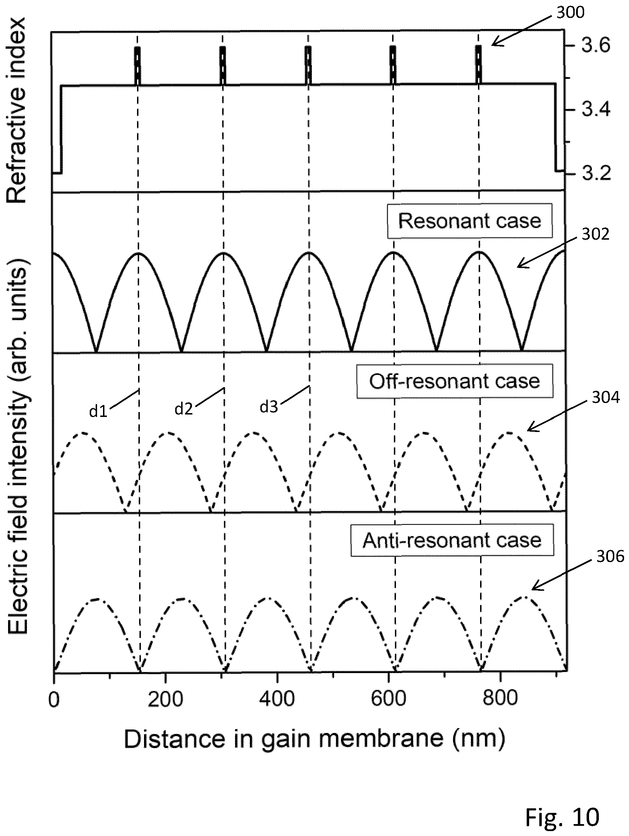

By way of appropriately selecting or adjusting the first optical path length L1 between the periodic gain structure 16 and the first reflector 12 there can be provided a rather precise gain adjustment and spectral filtering of the resonant cavity 8 as will be explained below in connection with Figs. 10-12.

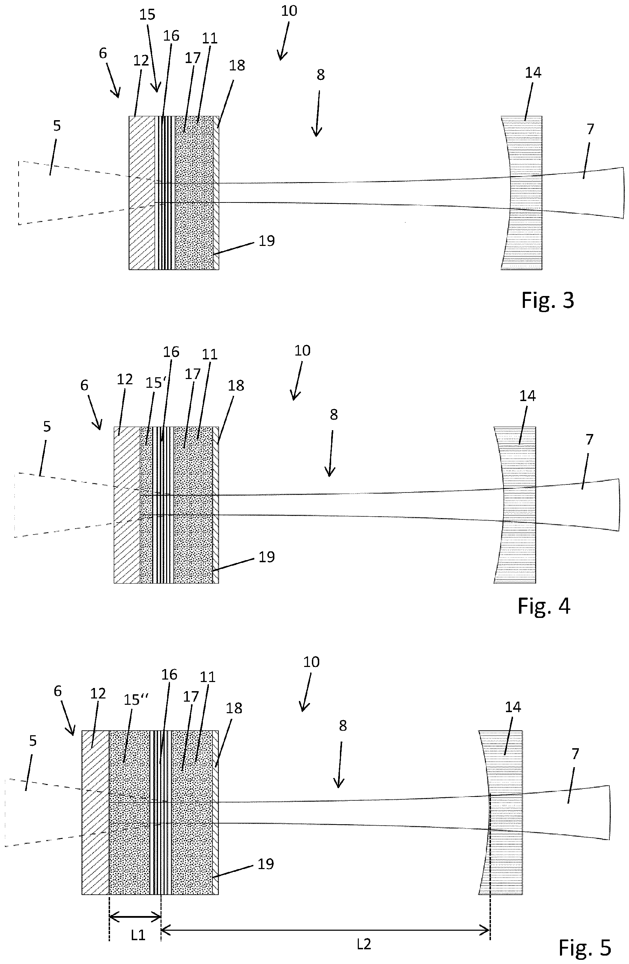

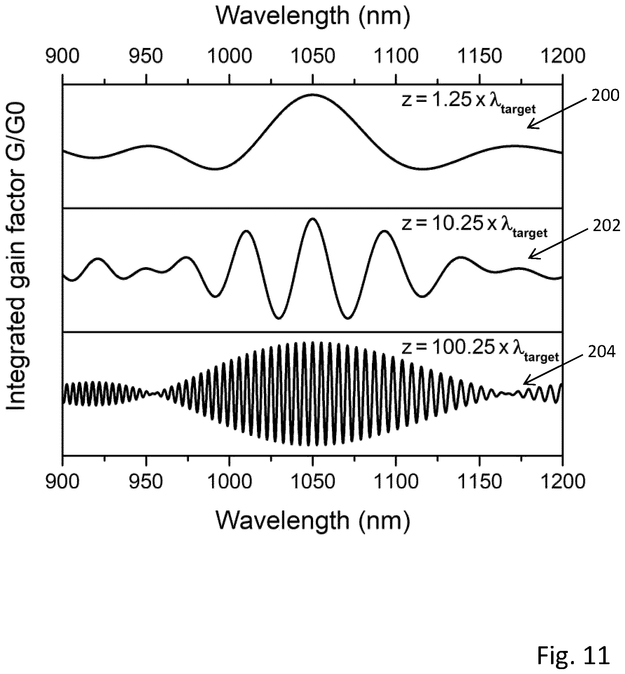

In the sequence of Figs. 3-5 there are illustrated three different cases of using spacers 15, 15', 15" of different size in longitudinal direction or of different thickness in longitudinal direction. The configuration of a spacer as shown in Fig. 3 may result in a spectral distribution of an integrated gain factor as illustrated in graph 200 of Fig. 11. The configuration of Fig. 4, with a spacer 15' larger than the spacer 15 according to Fig. 3 may coincide or may lead to an integrated gain factor as shown in graph 202 of Fig. 11 and a comparatively large spacer 15" may lead to a further integrated gain factor as shown in graph 204 of Fig. 11.

The gain factors over wavelength as shown in graphs 200, 202, 204 are calculated or simulated for a first optical path length L1 of 1.25 times a target wavelength as indicated in the diagram 200. For the diagram 202 there has been selected a first optical path length which equals 10.25 times the target wavelength and graph 204 represents an integrated gain factor for an optical path length of 100.25 times the target wavelength of the resonant cavity 8.

As illustrated in Fig. 11 and with an increase of the first optical path length L1 the spectral width of the integrated gain of the resonant cavity 8 will be reduced. For providing a rather easily controllable integrated gain it is of particular benefit to make use of a first optical path length L1 between the periodic gain structure 16 and the first reflector 12 in a region of larger than 5 times and less than 50 times of the target wavelength of the semiconductor laser or resonant cavity 8.

In Fig. 10 there are illustrated four different diagrams 300, 302, 304, 306 being illustrative of the refractive index of the periodic gain structure 16 along the longitudinal direction. The periodic gain structure comprises a periodic varying refractive index having rather sharp and selected peaks at distances d1, d2, d3 and so on as shown on graph 300. At the illustrated distances d1, d2, d3 the periodic gain structure 16 comprises a quantum well, which serves as laser gain structure.

In the graph 302 there is illustrated the electric field intensity of a standing intracavity radiation over longitudinal distance inside the periodic gain structure 16. Graph 302 represents a resonant case, where the local maximum and hence the standing wave maxima of the electric field intensity coincide(s) with the distances d1, d2, d3.

In the graph 304 there is illustrated an off-resonant case. Here, the maxima of the electric field intensity are longitudinally offset from the position or distances d1, d2, d3 which are characterizing the local maxima of the refractive index of the periodic gain structure 16. In graph 306 there is illustrated the anti-resonant case. Here, local minima of the electric field intensity of the emitted or intracavity radiation 7 coincide with the local maxima of the refractive index as provided by the periodic gain structure 16.

In order to optimize the gain of the optically pumped semiconductor laser 10 it is of particular benefit to precisely adjust the first optical path length between the periodic gain structure 16 and the first reflector 12 to obtain the resonant case as illustrated in graph 302.

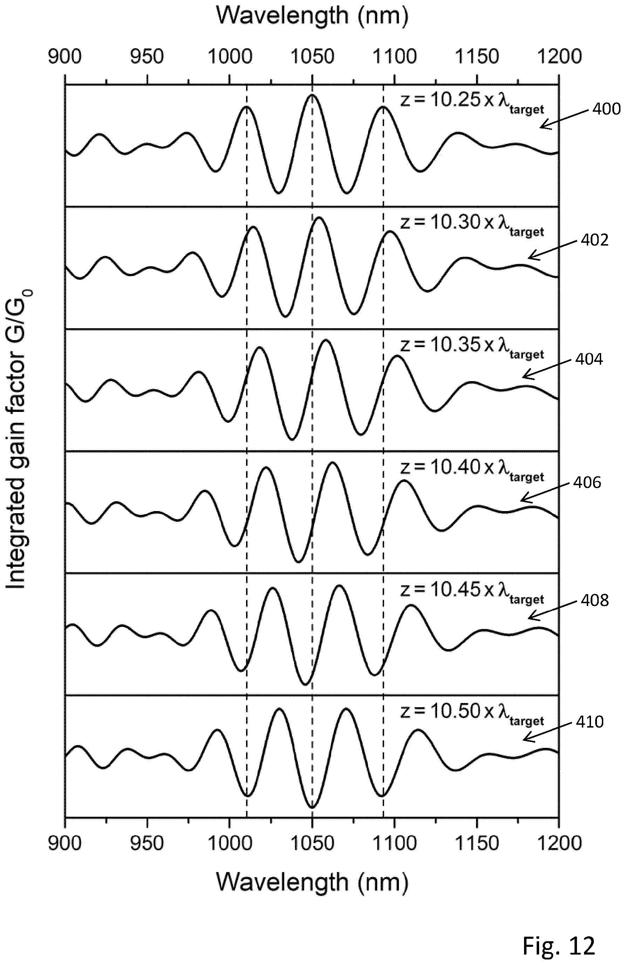

Such an adjustment is illustrated in the numerous graph 400, 402, 404, 406, 408 and 410 of Fig. 12. Here, graph 400 is illustrative of the integrated gain factor over the wavelength of the emitted radiation for an optical path length L1 of 10.25 times the measured target wavelength. Graph 402 shows the integrated gain factor for an optical path length L1 that equals 10.3 times the wavelength of the resonant cavity 8 or semiconductor laser 10. Graph 404 shows the integrated gain factor for an optical path length L1 that equals 10.35 times the wavelength of the resonant cavity 8 or semiconductor laser 10. Graph 406 shows the integrated gain factor for an optical path length L1 that equals 10.4 times the wavelength of the resonant cavity 8 or semiconductor laser 10. Graph 408 shows the integrated gain factor for an optical path length L1 that equals 10.45 times the wavelength of the resonant cavity 8 or semiconductor laser 10 and graph 410 shows the integrated gain factor for an optical path length L1 that equals 10.5 times the wavelength of the resonant cavity 8 or semiconductor laser 10.

The wavelength or target wavelength of the resonant cavity 8 can be adjusted or (fine) tuned by varying the total optical path length between the first reflector 12 and the second reflector 14.

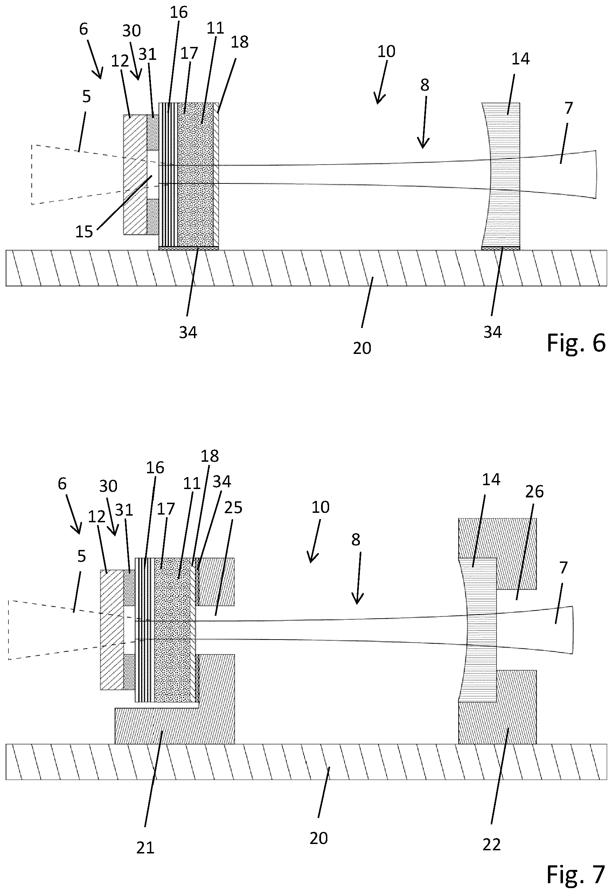

In Figs. 6-9 there are illustrated numerous examples of implementing the optically pumped semiconductor laser 10. With these examples there is provided a base 20 on which all components of the optically pumped semiconductor laser 10 are mounted. In the example of Fig. 6 the second reflector 14 and the semiconductor laser chip 6 are both fixed or mounted on the base 20 by way of a joint 34. The joint 34 may comprise a glue, a thermally conducting epoxy and/or solder or solder alloy, such as AuSn or SAC alloy (comprising SnAgCu) by way of which the reflector 14 and/or the laser chip 6 can be fastened and fixed to the base 20.

Here, the first reflector 12 is adjustably fastened to the chip by way of an adjustable spacer 30. The adjustable spacer may be configured to vary its longitudinal extent along the longitudinal direction z. For this, the adjustable spacer 30 may comprise an actuator 31, e.g. in form of a MEMS or piezo driven actuator that provide an adjustable length or thickness of the adjustable spacer 30 along the longitudinal direction z. In this way, a free space or gap and hence a space 15 between the periodic gain structure 16 and the first reflector 12 can be suitably adjusted.

Here, the first reflector 12 is fastened to the base 20 by way of the adjustable spacer 30. It has no direct connection to the base 20. In the example of Fig. 6 the second reflector 14 as well as the semiconductor laser chip 6 are mounted on the base, e.g. by way of a suitable joint 34, e.g. by an adhesive or solder.

In the further example of Fig. 7 there are provided specific mounts 21 and 22 for the semiconductor laser chip 6 and for the second external cavity reflector 14, respectively. Here, the first mount 21 and the second mount 22 may each comprise an aperture 25, 26 to provide free propagation of the emitted radiation 7 or intracavity radiation as emitted by the optically pumped periodic gain structure 16.

Here, the first reflector 12 is mounted to the periodic gain structure 16 in a manner as described above in connection with Fig. 6. The laser chip 6 may be fastened to the first mount 21 by way of a joint 34. Here, the multilayer laser chip 6 is mounted across the aperture 25 of the first mount 21.

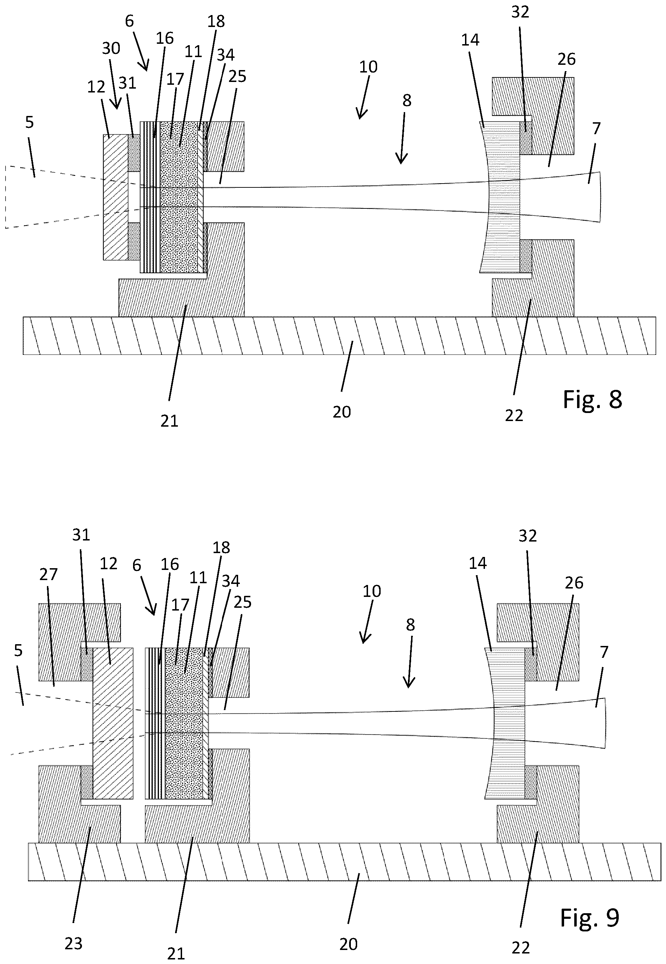

In the further example according to Fig. 8 also the second reflector 14 is adjustably arranged on the second mount 22. Here, the second reflector 14 is fastened to the second mount 22, e.g., across the aperture 26 of the second mount 22 via a second actuator 32. By way of the second actuator 32 a longitudinal position of the second reflector 14 relative to the base 20 and hence relative to any one of the first and second mounts 21, 22 can be adjusted or modified.

In this way, the total length of the resonant cavity 8 can be adjusted independently of the longitudinal distance or first optical path length L1 between the first reflector 12 and the periodic gain structure 16. By way of adjusting the total length of the resonant cavity 8 there can be provided a fine tuning of the target wavelength of the resonant cavity 8.

The laser chip 6 as shown in the example of Fig. 8 is mounted in the same or like manner as described above in connection with Fig. 7.

In the further example according to Fig. 9 the first reflector 12 may be separated from the laser chip 6. Here, the first reflector 12 may be mounted or fastened to the base 20 via a third mount 23. The third mount 23 comprises an aperture 27 across which the second reflector 12 is mounted. Between the third mount 23 and the first reflector 12 there is provided the electrically controllable actuator 31 by way of which a longitudinal position of the first reflector 12 can be adjusted or modified relative to the mount 23 and hence relative to the periodic gain structure 16, which may be fixed to the base 20 via the first mount 21.

Here, both reflectors 12, 14 are separately provided and mounted to individual mounts 22, 23 in an adjustable manner, e,g, through first and second electrical controllable actuators 31, 32. In this way, there can be provided an adjustment of the first optical path length L1 independent of the second optical path length L2.

In a further example it is also conceivable to fix at least one of the reflectors 12, 14 to the base 20 and to adjustably move the semiconductor laser chip 6 and/or its periodic gain structure 16 relative to the base 20. Here and in a likewise manner as described above there may be provided an independent adjustment of the first optical path length L1 and the total path length (L1 + L2) between the first and the second reflectors 12, 14.

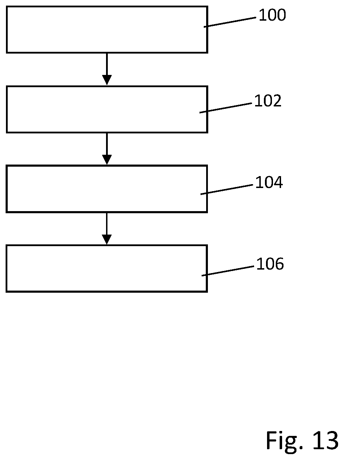

In the flowchart according to Fig. 13 there is illustrated a method of tuning the optically pumped semiconductor laser 10. Here and in a first step 100 the optically pumped semiconductor laser 10 as described above is provided. In step 102 the first optical path length L1 between the periodic gain structure 16 and the first reflector 12 is adjusted. For this and in a subsequent step 104 the longitudinal position of the first reflector 12 relative to the periodic gain structure 16 is adjusted. For this, the longitudinal extent of the spacer 15, 30 is varied, a refractive index of the spacer, which is located in the optical path between the periodic gain structure 16 and the first reflector 12 is varied and/or the selected and arranged one or several spacers 15 from a set of spacers 15', 15" of different longitudinal size or thickness.

In a subsequent step 106 the second optical path L2 and/or the overall optical path length of the resonant cavity 8 is adjusted, e.g. by moving or appropriately positioning the second reflector 14 with respect to its longitudinal position or longitudinal direction.

### Reference Numerals

- 5: pump radiation
- 6: chip
- 7: emitted radiation
- 8: cavity
- 10: semiconductor laser
- 11: substrate
- 12: reflector
- 14: reflector
- 15: spacer
- 16: periodic gain structure
- 17: heat spreader
- 18: coating
- 19: surface
- 20: base
- 21: mount
- 22: mount
- 23: mount
- 25: aperture
- 26: aperture
- 27: aperture
- 30: adjustable spacer
- 31: actuator
- 32: actuator
- 34: joint
- 40: crystal
- 42: coupler

## Claims

1. A semiconductor laser (10) comprising:
- a first reflector (12),
- a second reflector (14) separated from the first reflector (12) along a longitudinal direction (z),
- a resonant cavity (8) confined by the first reflector (12) and by the second reflector (14),
- a periodic gain structure (16) inside the resonant cavity (8), the periodic gain structure (16) is separated from the first reflector (12) by a first optical path length (L1) and is separated from the second reflector (14) by a second optical path length (L2), wherein the first optical path length (L1) is shorter than the second optical path length (L2), **characterized in that**
- the first optical path length (L1) between the periodic gain structure (16) and the first reflector (12) is adjustable.

2. The semiconductor laser (10) according to claim 1, wherein a longitudinal distance between the first reflector (12) and the periodic gain structure (16) is adjustable.

3. The semiconductor laser (10) according to any one of the preceding claims, wherein the first reflector (12) is movable in longitudinal direction (z) relative to the periodic gain structure (16).

4. The semiconductor laser (10) according to any one of the preceding claims, wherein the periodic gain structure (16) is adjustably movable relative to at least one of the first reflector (12) and the second reflector (14) along the longitudinal direction (z).

5. The semiconductor laser (10) according to any one of the preceding claims, wherein the second reflector (14) is adjustably movable relative to at least one of the first reflector (12) and the periodic gain structure (16) along the longitudinal direction (z).

6. The semiconductor laser (10) according to any one of the preceding claims further comprising a planar substrate (11), wherein the periodic gain structure (16) is provided on and extends across one side of the planar substrate (11).

7. The semiconductor laser (10) according to claim 6, wherein the first reflector (12) is attached to the periodic gain structure (16).

8. The semiconductor laser (10) according to any one of the preceding claims, further comprising a spacer (15, 30) between the periodic gain structure (16) and the first reflector (12) and wherein the first optical path length (L1) between the first reflector (12) and the periodic gain structure (16) is adjustable by at least one of:
- varying a longitudinal extent of the spacer (15, 30),
- varying a refractive index of the spacer (15, 30),
- selecting one or numerous spacers (15) from a set of spacers (15', 15") of different longitudinal size.

9. The semiconductor laser (10) according to any one of the preceding claims, further comprising a first electrically controllable actuator (31) mechanically connected to at least one of the first reflector (12) and the periodic gain structure (16) and operable to adjust the first optical path length (L1) between the first reflector (12) and the periodic gain structure (16) by varying a longitudinal distance between the first reflector (12) and the periodic gain structure (16).

10. The semiconductor laser (10) according to any one of the preceding claims, further comprising a second electrically controllable actuator (32) mechanically connected to at least one of the second reflector (14) or the periodic gain structure (16) and operable to adjust the second optical path length (L2) between the second reflector (14) and the periodic gain structure (16) by varying a longitudinal distance between the second reflector (14) and the periodic gain structure (16).

11. The semiconductor laser (10) according to any one of the preceding claims, wherein the optical path length between the first reflector (12) and the periodic gain structure (16) is larger than 5 times or larger than 10 times a target wavelength of the semiconductor laser (10).

12. The semiconductor laser (10) according to any one of the preceding claims, further comprising a heat spreader (17) in thermal contact with the periodic gain structure (16).

13. The semiconductor laser (10) according to claim 12, wherein the heat spreader (17) comprises an outside surface (19) facing away from the periodic gain structure (16), wherein the outside surface (19) is provided with at least one of an at least partially reflective coating (18) and the second reflector (14).

14. A method of spectrally controlling a semiconductor laser (10) according to any one of the preceding claims, the method comprising the steps of:
- providing the semiconductor laser (10) according to any one of the preceding claims,
- adjusting the first optical path length (L1) between the periodic gain structure (16) and the first reflector (12).

15. The method according to claim 14 further comprising the step of:
- adjusting the second optical path length (L2) between the periodic gain structure (16) and the second reflector (14).
